(19) Europäisches Patentamt

European Patent Office

Office européen des brevets

(11) **EP 1 174 725 A2**

(12) **EUROPÄISCHE PATENTANMELDUNG**

(43) Veröffentlichungstag:
 **23.01.2002 Patentblatt 2002/04**

(51) Int Cl.$^7$: **G01R 33/46**

(21) Anmeldenummer: **01117257.4**

(22) Anmeldetag: **17.07.2001**

| | |
|---|---|
| (84) Benannte Vertragsstaaten: **AT BE CH CY DE DK ES FI FR GB GR IE IT LI LU MC NL PT SE TR** Benannte Erstreckungsstaaten: **AL LT LV MK RO SI** | (71) Anmelder: **Universitätsklinikum Freiburg 78106 Freiburg (DE)** |
| (30) Priorität: **18.07.2000 DE 10035319** | (72) Erfinder: **Hennig, Jürgen 79100 Freiburg (DE)** |
| | (74) Vertreter: **KOHLER SCHMID + PARTNER Patentanwälte GbR, Ruppmannstrasse 27 70565 Stuttgart (DE)** |

(54) **Verfahren zur Messung der Magnetresonanz (=NMR) mittels Spin-Echos**

(57) Ein Verfahren der NMR-Spektroskopie bzw. -Tomographie, bei welchem auf ein Spinensemble eine Folge von zeitlich gegeneinander versetzten Hochfrequenzimpulsen angewendet wird, ist dadurch gekennzeichnet, dass nach einer Sequenz von Pulsen mit Flipwinkel $\alpha_1 ... \alpha_n$ (mit $\alpha_1 ... \alpha_n \geq 0°$) und Phasen $\phi_1...\phi_n$, zwischen denen Spins jeweils Dephasierungen $\varphi_1...\varphi_n$ erfahren, als (n+1)ter Puls ein zentraler Refokussierungspuls angewendet wird, gefolgt von einer Pulssequenz, deren Folge spiegelsymmetrisch zum zentralen Refokussierungspuls ist, wobei die Flipwinkel $\alpha_{n+2} ... \alpha_{2n+1}$ und Phasen $\phi_{n+2}...\phi_{2n+1}$ der Pulse im Vergleich mit den dazu spiegelsymmetrisch angeordneten Pulsen mit $\alpha_n ... \alpha_1$ und $\phi_n...\phi_1$ in Bezug auf Amplitude und Phase jeweils negatives Vorzeichen aufweisen und die in der Folge ebenfalls spiegelsymmetrisch zum zentralen Refokussierungspuls angeordneten Dephasierungen $\varphi_{n+2}...\varphi_{2n+1}$ den jeweiligen spiegelsymmetrischen Dephasierungen $\varphi_n...\varphi_1$ gleich sind, so dass am Ende der Pulsfolge eine Ausgangsmagnetisierung $M_A(Mx,My,Mz)$ des Spinensembles bezüglich des zentralen Refokussierungspulses durch Anwendung einer Rotation entsprechend der Symmetriebeziehung

$$M_R(-Mx,My,-Mz) = Rot_y(180°) * M_A(Mx,My,Mz)$$

in eine Endmagnetisierung $M_R = (-Mx,My,-Mz)$ refokussiert ist (=Hyperecho-Bildung). Damit lassen sich auch nach Anwendung von Refokussierungsimpulsen beliebiger Flipwinkel die auftretenden Signalverluste rückgängig machen und bezüglich der Dephasierung durch chemische Verschiebung, Suszeptibilität und Feldinhomogenität die volle Signalamplitude wiederherstellen.

Fig.2

EP 1 174 725 A2

**Beschreibung**

Die Erfindung betrifft ein Verfahren der NMR-Spektroskopie bzw. Kernspintomographie, bei welchem auf ein Spinensemble eine Folge von zeitlich gegeneinander versetzten Hochfrequenzimpulsen angewendet wird, von denen mindestens einer als Refokussierungspuls ausgebildet ist.

Hinweise auf die anhängende Literaturliste werden im Folgenden durch "D" und entsprechende Ziffern in runden Klammern gegeben.

Die Messung eines Kernresonanzsignals erfolgt häufig mittels des aus (D1) bekannten Spin-Echo Verfahrens. Hierbei wird die angeregte Magnetisierung nach einer Periode te/2 durch einen Refokussierungspuls invertiert und es kommt nach einer weiteren Zeit te/2 zur Bildung eines Spin-Echos. Zum Zeitpunkt des Spin-Echos werden auf die Spins einwirkenden Effekte wie chemische Verschiebung, Suszeptibilität, Feldinhomogenität refokussiert, so dass sämtliche Spins bezüglich dieser Effekte eine kohärente Signalphase aufweisen. Das Signalmaximum wird dabei erreicht, wenn der Flipwinkel des Refokussierungspulses exakt 180° beträgt. Ein solcher idealer Flipwinkel ist in der Praxis immer nur annähernd realisierbar, so dass sich insbesondere bei Verfahren, welche auf der Bildung vieler Spin-Echos beruhen, Signalverluste auf Grund der Abweichung des Flipwinkels der Refokussierungspulse von 180° ergeben.

Eine solche Abweichung kann entweder durch technische Gegebenheiten auftreten oder aber auch absichtlich erfolgen, z.B. bei Anwendungen am Menschen zur Einhaltung von Grenzwerten für die abgestrahlte Hochfrequenzenergie (SAR = specific absorption rate). In der Literatur wurde eine Reihe von Maßnahmen vorgeschlagen, mit welchen die entsprechenden Signalverluste begrenzt werden können. Dies ist zum einen das sogenannte Carr-Purrcell-Meiboom-Gill Verfahren (D2), bei welchem durch entsprechende Verschiebung der Signalphase zwischen Anregungs- und Refokussierungspulsen eine teilweise Selbstkompensation der Refokussierungspulse bewirkt wird.

Es konnte gezeigt werden, dass mit einer solchen Sequenz bei langen Echozügen selbst bei kleinen Refokussierungsflipwinkeln hohe Echoamplituden erzielt werden können (D3).

Bei Verwendung unterschiedlicher Flipwinkel über die ersten Refokussierungsperioden des Multiechozuges lässt sich die Echoamplitude noch weiter steigern (D4)(D5).

In Anwendungen der analytischen NMR-Spektroskopie finden auch Verbesserungen durch unterschiedliche Phasenzyklen wie MLEV16 oder XY16 Anwendung (D6). Diese dienen vor allem zur Restkompensation kleiner Fehler bei Refokussierungspulsen mit annähernd 180° Flipwinkel.

Allen in der Literatur bekannten Verfahren ist gemeinsam, dass bei Abweichung des Flipwinkels auch nur eines einzelnen Refokussierungsimpulses von 180° ein Signalverlust auftritt, welcher durch entsprechende Ausgestaltung der nachfolgenden Refokussierungsimpulse bestenfalls abgemildert werden kann.

Aufgabe der vorliegenden Erfindung ist es demgegenüber, eine Methode vorzustellen, mit welcher es gelingt, auch nach Anwendung von Refokussierungsimpulsen beliebiger Flipwinkel die auftretenden Signalverluste rückgängig zu machen und bezüglich der Dephasierung durch chemische Verschiebung, Suszeptibilität und Feldinhomogenität die volle Signalamplitude wiederherzustellen.

Erfindungsgemäß wird diese Aufgabe auf überraschend einfache, aber wirkungsvolle Art und Weise dadurch gelöst, dass nach einer Sequenz von Pulsen mit Flipwinkel $\alpha_1 ... \alpha_n$ (mit $\alpha_1 ... \alpha_n \geq 0°$) und Phasen $\phi_1...\phi_n$, zwischen denen Spins jeweils Dephasierungen $\varphi_1...\varphi_n$ erfahren, als (n+1)ter Puls ein zentraler Refokussierungspuls angewendet wird, gefolgt von einer Puls-sequenz, deren Folge spiegelsymmetrisch zum zentralen Refokussierungspuls ist, wobei die Flipwinkel $\alpha_{n+2} ... \alpha_{2n+1}$ und Phasen $\phi_{n+2}...\phi_{2n+1}$ der Pulse im Vergleich mit den dazu spiegelsymmetrisch angeordneten Pulsen mit $\alpha_n ... \alpha_1$ und $\phi_n...\phi_1$ in Bezug auf Amplitude und Phase jeweils negatives Vorzeichen aufweisen und die in der Folge ebenfalls spiegelsymmetrisch zum zentralen Refokussierungspuls angeordneten Dephasierungen $\varphi_{n+2}...\varphi_{2n+1}$ den jeweiligen spiegelsymmetrischen Dephasierungen $\varphi_n...\varphi_1$ gleich sind, so dass am Ende der Pulsfolge eine Ausgangsmagnetisierung $M_A(Mx,My,Mz)$ des Spinensembles bezüglich des zentralen Refokussierungspulses durch Anwendung einer Rotation entsprechend der Symmetriebeziehung

$$M_R(-Mx,My,-Mz) = Rot_y(180°) * M_A(Mx,My,Mz)$$

in eine Endmagnetisierung $M_R = (-Mx,My,-Mz)$ übergeführt und unter Vernachlässigung von Relaxationseffekten refokussiert ist.

Die durch die erfindungsgemäße Pulsfolge bewirkte Refokussierung der anfänglichen Magnetisierung $M_A$ wird als Hyperecho-Bildung bezeichnet.

Methode

Die Grundidee basiert auf Symmetriebetrachtungen der Rotation: Wir betrachten Rotationen von Vektoren, für welche gilt:

Drehung um die z-Achse um einen Winkel $\varphi$:

$$\text{Rot}_z(\varphi_n) = \begin{vmatrix} \cos(\varphi_n) & \sin(\varphi_n) & 0 \\ -\sin(\varphi_n) & \cos(\varphi_n) & 0 \\ 0 & 0 & 1 \end{vmatrix} \qquad [1]$$

Drehung um die y-Achse um einen Winkel $\alpha$:

$$\text{Rot}_y(\alpha_n) = \begin{vmatrix} \cos(\alpha_n) & 0 & -\sin(\alpha_n) \\ 0 & 1 & 0 \\ \sin(\alpha_n) & 0 & \cos(\alpha_n) \end{vmatrix} \qquad [2]$$

Eine Rotation $\text{Rot}_\phi(\alpha)$ um eine Drehachse, welche in der x-y-Ebene um einen Winkel $\phi$ gegenüber der y-Achse gekippt ist, lässt sich beschreiben als:

$$\text{Rot}_\phi(\alpha) = \text{Rot}_z(\phi_n)\, \text{Rot}_y(\alpha_n)\, \text{Rot}_z(-\phi_n) \qquad [3]$$

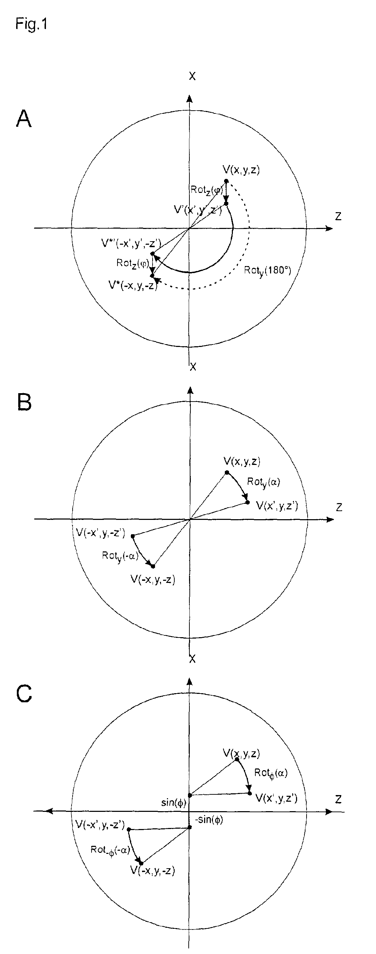

Entsprechend den Konventionen der Matrixmultiplikation erfolgt die Berechnung von rechts nach links.
Betrachtet man zwei Vektoren V(x,y,z) und V*(-x,y,-v), welche bezüglich einer Rotation um 180° um die y-Achse symmetrisch angeordnet sind, so lässt sich leicht zeigen (Figuren 1A-1C):

L1: Eine Drehung $\text{Rot}_z(\varphi)$ eines Vektors V(x, y, z) um die z-Achse um einen Winkel $\varphi$ erzeugt den resultierenden Vektor V'(x',y',z). Für einen zu V bzgl. der y-Achse um 180° gedrehten Vektor V*(-x, y, -z) geht der zu V' korrespondierende Punkt V*'(-x',y',-z) aus V* durch Drehung um -$\varphi$ hervor (Fig.1A).

V lässt sich also durch Rotation um z mit einem Drehwinkel $\phi$, anschliessende Rotation um y mit einem Drehwinkel 180° und anschliessende Rotation um z mit $\phi$ in V* überführen:

$$V^*(-x, y, -z) = \text{Rot}_z(\varphi)^*\text{Rot}_y(180°)^*\text{Rot}_z(\varphi)^*V(x, y, z)$$

$$= \text{Rot}_y(180°)\, V(x, y, z). \qquad [4]$$

L2: Eine Drehung $\text{Rot}_y(\alpha)$ von V um die y-Achse um einen Winkel $\alpha$ erzeugt den resultierenden Vektor V'(x',y,z'). Der dazu korrespondierende symmetrische Punkt V*'(-x',y',-z) geht aus V* ebenfalls durch Drehung um $\alpha$ hervor.

Es gilt also durch triviale Addition der Drehwinkel (Fig.1B):

$$V^*(-x, y, -z) = \text{Rot}_y(\alpha)^*\text{Rot}_y(180°)^* \text{Rot}_y(-\alpha)^*V(x, y, z)$$

$$= \text{Rot}_y(180°)\, V(x, y, z). \qquad [5]$$

Aus L1 und L2 folgt mit Gl.[3]:

L3: Eine Drehung $\text{Rot}_\phi(\alpha)$ von V um eine bezüglich der y-Achse um $\phi$ gekippte Achse mit einem Winkel $\alpha$ erzeugt den resultierenden Vektor V'(x',y,z'). Der dazu korrespondierende symmetrische Punkt V*'(-x',y',-z) geht aus V* durch Drehung $\text{Rot}_{-\phi}(\alpha)$ um eine bezüglich der y-Achse um -$\phi$ gekippte Rotationsachse hervor. Es gilt also (Fig. 1C)

$$V^*(-x, y, -z)= Rot_{-\phi}(-\alpha)*Rot_y(180°)* Rot_{\phi}(\alpha)*V(x, y, z)$$

und mit Gln. [3] - [5]:

$$V^*(-x, y, -z)= Rot_z(\phi_n) *Rot_y(-\alpha_n) *Rot_z(-\phi_n) *Rot_y(180°) *Rot_z(-\phi_n) *Rot_y(\alpha_n)$$

$$*Rot_z(\phi_n) *V(x, y, vz) = Rot_y(180°) V(x, y, z). \qquad [6]$$

Eine Rotation mit -$\alpha$ um eine Achse -$\phi$ entspricht einer Rotation mit $\alpha$ um 180°-$\phi$:

$$Rot_{-\phi}(-\alpha) = Rot_{180°-\phi}(\alpha) \qquad [7]$$

Beide Nomenklaturen sind äquivalent und werden im folgenden je nach Praktikabilität verwendet.
Diese zunächst rein mathematischen Symmetriebeziehungen lassen sich in Pulsfolgen der NMR-Spektroskopie bzw. MR-Tomographie umsetzen. So ist Gleichung [4] die Grundlage des Spin-Echo Experimentes von Hahn, denn es besagt:
Durch eine Dephasierung $Rot_z(\phi)$ angewendet auf eine Magnetisierung $M_A(-Mx,My,-Mz)$ definiert als

$$M_A(Mx,My,Mz) = \begin{vmatrix} Mx \\ My \\ Mz \end{vmatrix}$$

anschließende Refokussierung durch einen 180°-Puls $Rot_y(180°)$ und weitere Phasenentwicklung entsprechend $Rot_z(\phi)$ entsteht eine Magnetisierung $M_R(-Mx,My,-Mz)$, welche gegenüber $M_A$ rotationssymmetrisch ist.
Entsprechend Gl. [4] gilt daher

$$M_R(-Mx,My,-Mz) = Rot_z(\phi)*Rot_y(180°) *Rot_z(\phi)*M_A(-Mx,My,-Mz)$$

$$= Rot_y(180°) * M_A(Mx,My,Mz) \qquad [8]$$

das heißt, durch einen 180°-Puls werden Spins unabhängig von ihrer Phasenentwicklung $\phi$ refokussiert.
Die Phasenentwicklung um $\phi$ kann dabei entweder durch zeitlich konstante Mechanismen wie chemische Verschiebung, Inhomogenitäten etc. bewirkt werden, wobei die Dephasierung dann durch eine Off-Resonanzfrequenz charakterisiert $\omega$ ist und $\phi$ entsprechend $\phi = \omega t$ proportional zu den jeweiligen Zeitintervallen wird. $\phi$ kann aber auch durch veränderliche Größen wie Magnetfeldgradienten oder Bewegung in inhomogenen Feldern bestimmt sein. Übertragen auf die NMR entspricht die in den Gleichungen [5]-[7] beschriebene Rotation um eine Drehachse in der x-y-Ebene der Anwendung eines Hochfrequenzimpulses mit Flipwinkel $\alpha$.
Geht man nun von der Spin-Echo Sequenz entsprechend [8] aus, so lässt sich diese nun nach L1-L3, Gln. [4]-[7] unter Erhaltung der Rotationssymmetrie symmetrisch erweitern, wobei die Sequenz beiderseits entweder um ein Dephasierungsintervall entsprechend Gl.[4] oder einen Puls entsprechend Gln. [5]-[7] erweitert wird.
Im allgemeinen ist es üblich, Pulssequenzen in der MR als alternierende Folge von Pulsen und nachfolgenden Zeitintervallen darzustellen und im folgenden soll diese Darstellung verwendet werden. Alle Aussagen treffen natürlich auch auf Sequenzen zu, bei welchen mehrere Hochfrequenzimpulse unmittelbar aufeinanderfolgen oder die mehrere Dephasierungsschritte zwischen 2 Hochfrequenzimpulsen beinhalten.
Insbesondere kann die zeitliche Entwicklung zwischen zwei Pulsen beliebig sein, entscheidend ist lediglich die Gesamtdephasierung zwischen aufeinanderfolgenden Pulsen. Demgemäß lässt sich das erfindungsgemäße Verfahren formulieren als:
Mehrpulssequenz in der NMR-Spektroskopie oder MR-Tomographie, bei welchem auf ein Spinsystem mit einer Magnetisierung $M_A(Mx,My,Mz)$ eine Folge von 2n+1 Hochfrequenzpulsen angewendet wird, charakterisiert dadurch, dass zunächst n Hochfrequenzpulse $R(\alpha_n,\phi_n)$ mit jeweiligem zeitlichen Abstand $t_n$ angewendet werden, welche auf die Spins eine Rotation $Rot_{\phi n}(\alpha_n)$ ausüben, wobei die Spins in den Zeitintervallen $I_n$ zwischen den Pulsen eine Phasenentwicklung um $\phi_n$ entsprechend einer Rotation $Rot_z(\phi_n)$ um z erfahren, anschließend ein Refokussierungspuls $R(\alpha_{n+1},\phi_{n+1})= R(180°,0°)$ gefolgt von n Hochfrequenzpulsen $R(\alpha_{n+2},\phi_{n+2})...R(\alpha_{2n+1},\phi_{2n+1})$ in zeitlich umgekehrter Reihenfolge und entsprechend der durch Gln. [5]-[7] gegebenen Beziehung

$$R(\alpha_{n+2},\phi_{n+2})....\ R(\alpha_{2n+1},\phi_{2n+1})= R(-\alpha_n,-\phi_n)...\ R(-\alpha_1,-\phi_1)=$$

$$R(\alpha_n,180°-\phi_n)...\ R(\alpha_1,\ 180°-\phi_1) \qquad [9]$$

und

$$\phi_{n+1}...\ \phi_{2n} = \phi_n...\ \phi_1 \qquad [10]$$

wodurch eine Magnetisierung $M_R$ erhalten wird, für welche gilt:

$$M_R(-Mx,My,-Mz) = Rot_y(180°) * M_A(Mx,My,Mz), \qquad [11]$$

das heißt, die Ausgangsmagnetisierung $M_A$ wird unabhängig von $\alpha_n,\phi_n$ und $\phi_n$ refokussiert.

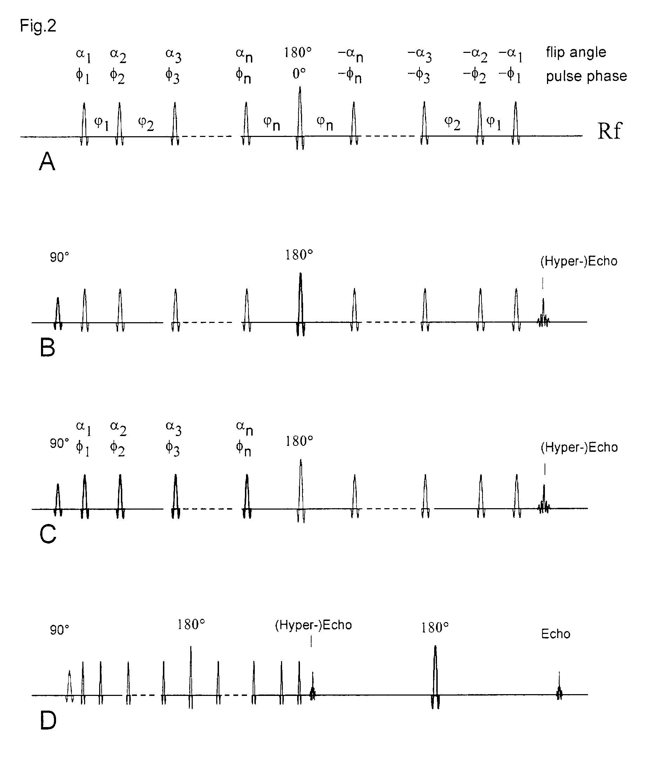

Diese Folge ist in Fig.2 bildlich dargestellt.

Entsprechend dem Grundprinzip, dass sich Hochfrequenzimpulse mit kompliziertem Amplituden- und Phasenprofil (wie sie etwa zur Schichtselektion in der Kernspintomographie verwendet werden) als Folge kurzer Pulse mit diskretem Flipwinkel darstellen lassen, gelten die Gleichungen [9]-[11] analog auch für Pulssequenzen mit amplituden- und/oder phasenmodulierten Pulsen. Zudem soll darauf hingewiesen werden, dass die Phase des zentralen Refokussierungspulses per definitionem auf den Wert 0° gesetzt wurde und nicht notwendigerweise mit der Referenzphase der Magnetisierung übereinstimmen muss. Durch Koordinatentransformation von Gln.[9]-[11] entsprechend Gl.[3] ist die Gültigkeit der Refokussierungsbeziehung Gl.[11] auch für beliebige Phasen des zentralen Pulses gegeben, sofern eine entsprechende Transformation auch für die anderen Pulse durchgeführt wird.

Für einen zentralen Puls mit Phase $\zeta$, der eine Rotation entsprechend $(180°,\zeta)$ bewirkt, folgt dann aus Gl.[9]:

$$R(\alpha_{n+2},\phi_{n+2})....\ R(\alpha_{2n+1},\phi_{2n+1})=R(-\alpha_n,-\phi_n+2\zeta)...\ R(-\alpha_1,-\phi_1+2\zeta)=$$

$$R(\alpha_n,\ 180°-\phi_n+2\zeta)...\ R(\alpha_1,\ 180°-\phi_1+2\zeta) \qquad [12]$$

Der Vollständigkeit halber soll noch angemerkt werden, dass der zentrale Refokussierungsimpuls auch einen Flipwinkel von <180° aufweisen kann. Die Amplitude der gebildeten refokussierten Magnetisierung ist dann dementsprechend abgeschwächt.

Durch eine solche Pulsfolge werden alle Spins unabhängig von ihrer jeweiligen und gegebenenfalls unterschiedlichen Phasenentwicklung refokussiert und bilden ein kohärentes Spin-Echo. Dieser Vorgang der Refokussierung über eine Pulsfolge wird im folgenden Hyperecho-Bildung genannt.

Relaxationsvorgänge wurden in dieser Herleitung nicht berücksichtigt und führen zu einer relaxationsbedingten Signalabschwächung.

Aus dieser in Fig.2A gezeigten Grundsequenz lassen sich nun eine Reihe von Realisierungen auf der Basis bekannter Pulssequenzen ableiten. Die Einführung der Hyperecho-Bildung in eine bestehende Sequenz kann dabei auf unterschiedliche Arten geschehen:

Wie in Fig.2B gezeigt, kann eine bestehende Sequenz (hier eine einfache Spin-Echo Sequenz mit einem 90°-Anregungsimpuls und einem 180°-Refokussierungsimpuls) durch Einfügung weiterer Pulse entsprechend Gl.[9]-[11] zu einer Hyperecho-Sequenz modifiziert werden. Bei Sequenzen, deren Pulsfolge bereits den Dephasierungsbedingungen für die Hyperecho-Bildung erfüllt, ist hierbei ggf. lediglich eine Modifikation der Flipwinkel und Pulsphasen notwendig (s.u.).

Fig.2C zeigt das Prinzip der Integration der Hyperecho-Bildung durch Komplementierung: Eine beliebige Pulssequenz (hier bestehend aus einem Anregungsimpuls mit nachfolgenden n Hochfrequenzpulsen) wird durch Anfügen eines Refokussierungspulses mit nachfolgenden Pulsen entsprechend Gln.[9]-[11] komplementiert, so dass es zur Bildung eines Hyperechos kommt.

Fig.2D schließlich zeigt die Anwendung eines Hyperechos zur Präparation von Magnetisierung als Hyperecho, welche dann nachfolgend mit einer beliebigen Pulssequenz (hier: einfaches Spin-Echo) ausgelesen wird.

Natürlich lassen sich diese unterschiedlichen Arten der Einführung eines Hyperechos auch miteinander beliebig kombinieren, auch die Bildung mehrerer Hyperechos innerhalb einer Sequenz kann vorteilhaft sein.

Im folgenden sind einige Anwendungsbeispiele gezeigt. Hierbei muss darauf hingewiesen werden, dass in der NMR-Literatur eine extrem große Anzahl unterschiedlicher Mehrpulssequenzen existiert, welche im folgenden nur exemplarisch beschrieben werden können. Die Anwendung des durch die Gleichungen [9]-[11] beschriebenen Verfahrens der Symmetrisierung zur Bildung eines voll refokussierten Spin-Echos ist jedoch dem Fachmann ohne weiteres möglich, so dass die folgenden Beispiele keine Einschränkung darstellen, sondern lediglich der Illustration des allgemein anwendbaren Grundprinzips dienen.

Folgende Klassen von Anwendungen erscheinen vorteilhaft:

1. Multiecho-Sequenzen

Die Anwendung des durch GI.[11] beschriebenen Prinzips auf transversale Magnetisierung führt - bei Vernachlässigung von Relaxationseffekten - zur Wiederherstellung der vollen Magnetisierung (entsprechend der durchgängigen Verwendung von Refokussierungspulsen mit Flipwinkel 180°) für beliebige Werte von $\alpha_1 ... \alpha_n$. Während die Amplitude nach jedem durch $\alpha_n$ erzeugten Echos <<1 ist, wird nach der erfindungsgemäßen Sequenz die volle Amplitude wiederhergestellt.

Ein Spezialfall der Gln.[9]-[11] ist dann gegeben, wenn der Magnetisierungsvektor $M_A$ parallel zum zentralen Refokussierungspuls R(180°,0) ausgerichtet ist. In diesem Fall ist $M_R=M_A$, das heißt die Magnetisierung wird (abgesehen von Relaxationseffekten während der Sequenz) in sich selbst übergeführt. Dieser Fall ist zum Beispiel bei CPMG-Multiechoverfahren gegeben (D2), bei welchen die Magnetisierung durch einen 90°-Puls erzeugt wird. Bei der anschließenden mehrfachen Refokussierung werden 180°-Pulse mit zum Anregungsimpuls senkrechter und damit zur angeregten Magnetisierung paralleler Phase angewendet.

Bei solchen Sequenzen ist es in der klinischen Anwendung häufig notwendig, den Flipwinkel der Refokussierungspulse < 180° zu wählen, um die Hochfrequenzleistung zu begrenzen (D3). Eine Modifikation eines CPMG-Verfahrens nach dem erfindungsgemäßen Verfahren kann dann wie folgt realisiert werden:

Betrachtet man die Magnetisierung unmittelbar nach der Anregung als $M_A$ und vernachlässigt eventuelle Phaseneffekte während des Anregungspulses, so ist die Bedingung $M_A$ parallel zu R(180°,0) für alle nachfolgenden Refokussierungspulse erfüllt, es gilt daher für alle $\phi_n$:

$$\phi_n = \phi_0 = 0.$$

Auf Grund der äquidistanten Refokussierungspulse in CPMG-Sequenzen (und bei Verwendung von Magnetfeldgradienten entsprechenden Symmetriebedingungen für die durch diese bewirkte Dephasierung) gilt weiterhin für alle $\varphi_n$:

$$\varphi_n = \varphi_1$$

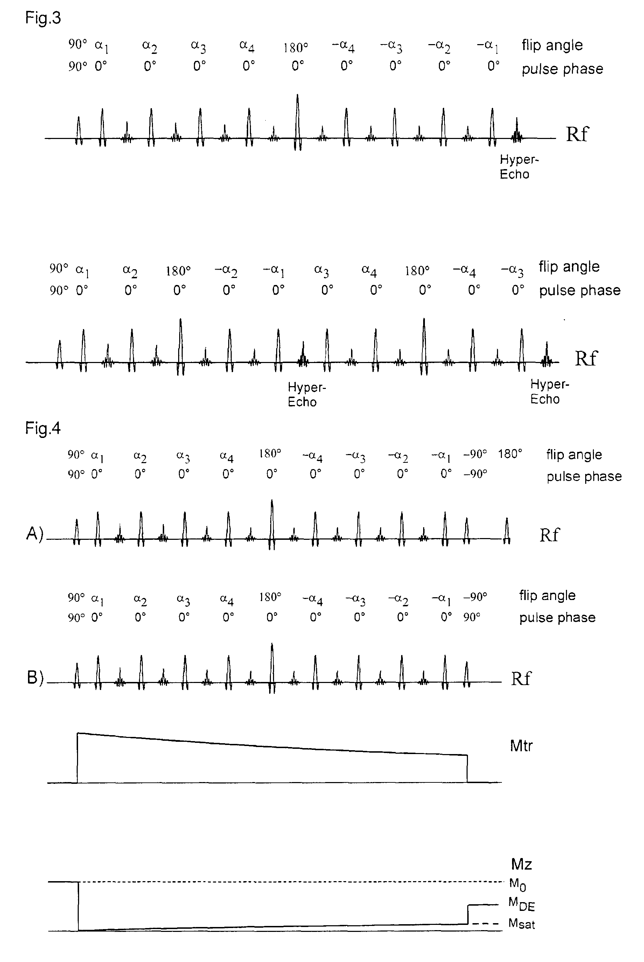

Die Symmetrie der erfindungsgemäßen Sequenz ist für diesen Fall durch Inversion der jeweilig angewendeten Flipwinkel erreicht, die Phasen bleiben durchgängig gleich Null (Fig.3):

$$R(\alpha_{n+2},0).... R(\alpha_{2n+1},0)= R(-\alpha_n,0)... R(-\alpha_1,0) \qquad [13]$$

Mit dieser Modifikation lässt sich dann für beliebige $\alpha_1 ... \alpha_n$ die Amplitude des (2n+1).ten Echos auf den voll refokussierten Wert (=1) wiederherstellen. Bei Verwendung einer solchen Sequenz in der MR-Tomographie entsprechend dem RARE-Verfahren ist der Bildkontrast im wesentlichen durch die Intensität des Echos, welches das Zentrum des k-Raums in Phasenkodierrichtung repräsentiert gegeben.

In einer bevorzugten Implementierung des erfindungsgemäßen Verfahrens ist es daher sinnvoll, genau für dieses Echo die volle Refokussierung wiederherzustellen. Hierbei wird dann die Signalintensität im Bild in erster Näherung unabhängig von $\alpha_1 ... \alpha_n$, eine Wahl von $\alpha_1 ... \alpha_n < 180°$ führt lediglich zu einer leichten Änderung der Bildschärfe. Sinnvoll ist es hierbei, für $\alpha_1 ... \alpha_n$ Werte zu wählen, welche eine möglichst hohe und homogene Echoamplitude erzeugen, wie dies z.B. in (D4) und (D5) beschrieben wird.

Insbesondere für sogenannte Multikontrast-Verfahren, bei welchen eine Phasenkodierung so durchgeführt wird, dass zumindest das Zentrum des k-Raums mehrfach und zu unterschiedlichen Echozeiten ausgelesen wird, lässt sich das Prinzip nach Gl.[12] auch während eines Echozugs mehrfach wiederholen, so dass mehrere Hyperechos in einem Echozug gebildet werden.

Das gewählte Beispiel der Anwendung auf eine RARE-Sequenz ist lediglich illustrativ. Hyperechos lassen sich auch in andere Bildgebungssequenzen wie GRASE, BURST etc. integrieren, um durch Refokussierung der Magnetisierung das Signalverhalten zu verbessern.

2. Driven Equilibrium-Sequenzen

Eine weitere besonders bevorzugte Anwendung des erfindungsgemäßen Verfahrens beschäftigt sich mit der Wiederherstellung der z-Magnetisierung bei sogenannten Driven Equilibrium (DEFT)-Sequenzen. Die Anwendung von DEFT auf Spin-Echo Sequenzen für die MR-Bildgebung wurde bereits 1984 beschrieben (D7). Es beruht auf der Anwendung eines sogenannten Flipback-Pulses zum Zeitpunkt der Echobildung, also wenn alle transversale Magnetisierung refokussiert ist. Durch diesen Flipback-Puls wird die verbleibende transversale Magnetisierung in z-Magnetisierung überführt. Diese ist damit näher am thermischen Gleichgewicht, so dass bei gleicher Erholzeit eine höhere Signalintensität erzielt werden kann.

In einer Hyperecho-Sequenz lässt sich eine solche Rückführung des Spinsystems in Richtung der Gleichgewichtsmagnetisierung auf zweierlei Arten realisieren: Wird die gesamte Sequenz entsprechend den Prinzipien der Hyperecho-Bildung ausgelegt und auf z-Magnetisierung angewandt, so wird die Magnetisierung zum Zeitpunkt der Hyperecho-Bildung entsprechend [11] als -z-Magnetisierung vorliegen. Diese kann dann durch einen unmittelbar nachfolgenden 180°-Puls in z-Magnetisierung überführt werden (Fig.4 A). Die gleiche Wirkung lässt sich auch erreichen, wenn der 90° Puls am Ende der Hyperecho-Sequenz in seiner Phase invertiert wird und dadurch als Flip-back Puls wirkt. Dadurch wird dann die Magnetisierung direkt in +z-Magnetisierung überführt (Fig.4 B).

Bei RARE (TSE...) Sequenzen mit kleinen Refokussierungsflipwinkeln (s.oben) lässt sich auf Grund der unvollständigen Refokussierung nur ein Teil der Magnetisierung mittels eines Flipback-Pulses wieder auf die z-Achse rotieren. Bei Anwendung des erfindungsgemäßen Verfahrens hingegen lässt sich die gesamte transversale Magnetisierung durch Bildung eines Hyperechos für den Zeitpunkt des Flipback-Pulses zurückgewinnen und durch Flip-back in z-Magnetisierung überführen.

Diese Anwendung ist vor allem (aber nicht ausschließlich) bei Anwendung an Hochfeldsystemen nützlich, wo zum einen auf Grund der erhöhten Hochfrequenzabsorption häufig kleine Refokussierungsflipwinkel verwendet werden und wo des weiteren auf Grund der mit zunehmender Feldstärke im allgemeinen längeren T1-Relaxationszeiten ohne Flipback lange Wiederholzeiten benötigt werden, um die Magnetisierung vor der nächsten Anregung möglichst nahe zum Gleichgewichtszustand zu bringen.

Besonders bevorzugt ist das Verfahren hier für solche Anwendungen, bei welchen inhärent eine kurze Wiederholzeit geboten ist wie z.B. Aufnahmen mit dreidimensionaler Ortskodierung oder auch schnell wiederholte Aufnahmen zur Beobachtung zeitlich veränderlicher Prozesse.

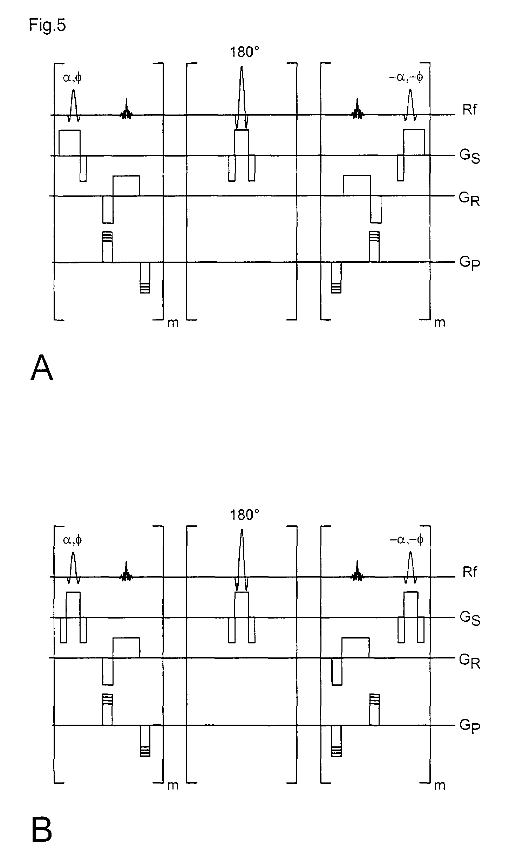

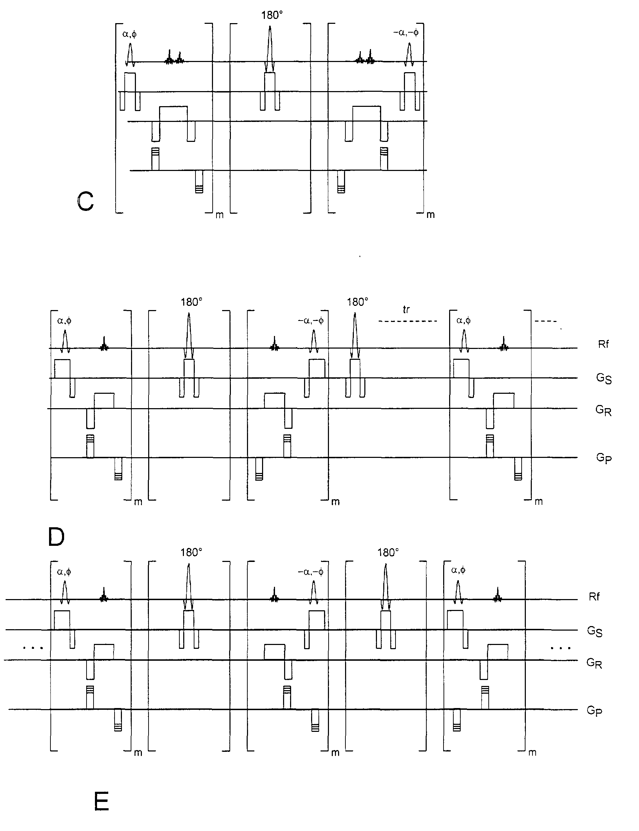

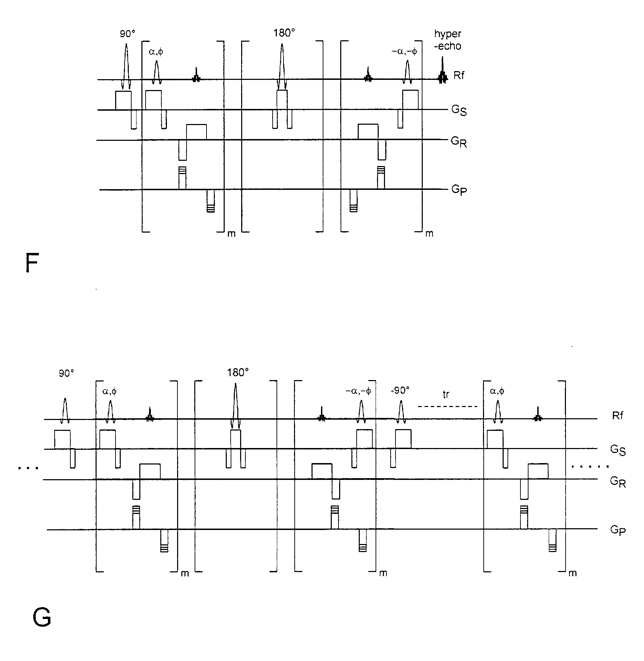

Auch Gradientenechosequenzen können mittels Hyperecho-Bildung refokussiert werden, indem nach Auslesung von m Anregungsintervallen, in welchen jeweils ein Gradientenecho erzeugt wird, ein 180°-Puls in die Sequenz eingefügt wird gefolgt von weiteren m Anregungsintervallen mit Pulsen entsprechend Gl.[11]. Fig.5A zeigt eine auf einer Gradientenecho-Sequenz aufgebaute Hyperecho-Sequenz. Hierbei wurde nach dem 180°-Puls die zeitliche Abfolge der gesamten Sequenz umgekehrt und die Pulse entsprechend [9]-[11] verändert. Der Einfachheit halber wurde in Fig.5A eine Sequenz mit konstantem Flipwinkel $\alpha$ gezeigt, unter Beachtung von [9]-[11] erfolgt natürlich auch für Sequenzen mit variablem $\alpha$ eine Hyperecho-Bildung.

In der gezeigten Form entsprechen die in der 2.Hälfte der Sequenz aufgenommenen Signale den durch den 180°-Puls refokussierten Signalanteilen. Da die Symmetriebedingung für die Hyperecho-Bildung lediglich für die gesamte Spin-Dephasierung zwischen jeweils zwei aufeinanderfolgenden Hochfrequenzpulsen gelten, führt auch die in Fig.5B gezeigte Sequenz zur Hyperecho-Bildung. Hier wurde gegenüber 5A lediglich der Lesegradient GR zeitlich invertiert (und der Schichtselektionsgradient GS symmetrisiert), so dass nunmehr auch in der zweiten Hälfte der Sequenz die durch den jeweils vorangehenden Hochfrequenzimpuls direkt erzeugten Gradientenechos gebildet werden. Bei Beachtung von [9]-[11] bezüglich der Gesamtdephasierung zwischen den Pulsen erfolgt auch hier die Bildung einer Hyperechos.

Durch geeignete Wahl der Gradienten lassen sich auch beide möglichen Signalgruppen auslesen (Fig.5 C). Diese können entweder separat erzeugt und ausgelesen werden. Bei Gestaltung des Lesegradienten GR so, dass die Gesamtfläche unter GR zwischen 2 Refokussierungspulsen gleich null wird, überlagern sich diese Signale zu einem einzigen Signal entsprechend dem Prinzip der FISP-Sequenz.

Die unter Fig.5A-C gezeigten Messverfahren lassen sich entweder so durchführen, dass die zur Bilderzeugung verwendeten Signale in einem einzigen Hyperecho-Zug aufgenommen werden. Die Durchführung kann aber auch so erfolgen, dass ein zur Bildrekonstruktion benötigter Datensatz erst nach mehrmaliger Wiederholung der entsprechenden Sequenzen erreicht wird. In besonders bevorzugten Implementierungen wird hierbei - wie bereits für Multi-echo Verfahren in Fig.4 gezeigt - die durch die Hyperecho-Bildung bewirkte Inversion der anfänglichen z-Magnetisierung vor der Erholzeit tr durch einen 180°-Puls invertiert und so näher zum Gleichgewichtszustand gebracht (Fig. 5D).

Schliesslich soll noch darauf hingewiesen werden, dass auch für Gradientenecho-Sequenzen eine Bildung mehrerer Hyperechos möglich ist (Fig.5E).

Bei Voranstellen eines Anregungspulses mit im allgemeinen, aber nicht zwangsläufig 90° Flipwinkel lässt sich das Hyperecho auch als Signal mit transversaler Magnetisierung bilden (Fig.5F), welches wiederum entsprechend der Beschreibung für Multischo-Sequenzen durch einen Flipback-Puls (Fig.5 G) vor der Erholzeit tr in z-Magnetisierung überführt werden kann. Für die in Fig.5D-G gezeigten Varianten wurde die generische Sequenz (Fig.5 A) zugrunde gelegt, sinngemäss lassen sich hier auch die Varianten entsprechend Fig5B,C (inkl. FISP) verwenden.

Zur Optimierung der steady-state Magnetisierung in kontinuierlichen Verfahren wie in Fig.5E kann es auch nützlich sein, den initialen Anregungsimpuls und den zur Hyperecho-Bildung eingesetzten Refokussierungspuls nicht als Pulse mit Flipwinkeln 90° und 180° zu realisieren, sondern Pulse mit entsprechend kleineren Flipwinkeln β (Anregung) bzw. 2β (Refokussierung) zu verwenden, wobei die Phase der Refokussierungspulse bei wiederholter Anwendung entsprechend dem Prinzip einer true FISP-Sequenz alterniert wird.

Auch in andere Bildgebungssequenzen wie echo planar imaging, spiral imaging etc. lassen sich Hyperechos integrieren, um damit das Kontrastverhalten z.B. entsprechend der Bildung des driven equilibrium zu modifizieren.

Die beschriebene Anwendung auf Messmethoden in der MR-Bildgebung sind lediglich illustrativ. Eine große Anzahl von Messsequenzen in der analytischen NMR - vor allem mehrdimensionale Fourier-Spektroskopie - wie COSY, NOESY, INEPT, INADEQUATE etc. - um nur einige der gängigen Sequenzen zu erwähnen, beruht auf mehrfachen Wiederholungen von Multipuls-Sequenzen. Bei allen diesen Sequenzen lässt sich durch Bildung eines Hyperechos mit anschließendem Flipback-Puls eine schnellere Einstellung der Gleichgewichtsmagnetisierung erreichen und damit eine Reduzierung der Messzeit und/oder eine Erhöhung des Signal-zu-Rausch Verhältnisses. Sofern bei solchen Sequenzen Pulse auf unterschiedliche Kerne angewendet werden, ist im allgemeinen die Bildung von Hyperechos auf sämtliche beteiligten Kerne vorteilhaft.

Besonders vorteilhaft ist die Verwendung von Hyperechoes in Driven Equilibrium Sequenzen vor allem zur Beobachtung von Kernen mit langem T1, da hier die Magnetisierung mit einer geeigneten Sequenz (z.B. der Bildgebung) ausgelesen werden kann und anschließend wieder als z-Magnetisierung gespeichert wird, um zu einem späteren Zeitpunkt erneut ausgelesen zu werden.

Eine bevorzugte Anwendung hierfür ist die Messung unter Verwendung hyperpolarisierter Magnetisierung (z. B. durch entsprechende Präparation hyperpolarisierte Edelgase). Hierbei wird die longitudinale Magnetisierung in einen Zustand weit weg vom thermischen Gleichgewicht präpariert, das so präparierte Spinsystem führt damit zu einer Signalintensität, die um Faktoren von mehreren tausend über der von Gleichgewichtsmagnetisierung führen. Solche hyperpolarisierten Substanzen werden z.B. in der MR-Tomographie unter Verwendung von hyperpolarisiertem Helium zur Darstellung der Lunge angewendet. Ein Problem hierbei stellt die Tatsache dar, dass die einmal angeregte Magnetisierung natürlich in den Gleichgewichtszustand relaxiert und die Polarisation damit verloren ist. Durch Verwendung von Flipback Sequenzen lässt sich die polarisierte Magnetisierung abzüglich der T2-bedingten Relaxationsverluste wiedergewinnen und damit mehrfach wiederverwenden.

3. Spin-Selektion

Hyperecho-Sequenzen können zur Selektion einer Untermenge der ursprünglich angeregten Spins verwendet werden, wenn eine Modifikation durchgeführt wird dergestalt, dass die zur Hyperecho-Bildung führende Symmetriebedingung GI.[11] nur für einen Teil der Spins erfüllt wird. Aus der Fülle der in der NMR-Literatur bekannten Sequenzen lässt sich eine große Anzahl solcher Anwendungen ableiten, die im folgenden nur illustrativ und keineswegs vollständig beschrieben werden können.

3.1. Spinselektion durch Variation der Symmetriebedingungen zur Hyperecho-Bildung

Eine Spinselektion in einem Hyperecho-Experiment ist dadurch realisierbar, dass die Pulsfolge so gewählt wird, dass die Symmetriebedingungen GI.[11] nur für einen Teil der zunächst angeregten Spins erfüllt ist. Dies lässt sich z.B. bei Anwendung schichtselektiver Pulse dadurch erreichen, dass die einzelnen Pulse durch Wahl entsprechender Pulsprofile jeweils nur auf Spins innerhalb eines bestimmten Frequenzbereichs wirken. Bei entsprechender Wahl der jeweiligen Frequenzbereiche lassen sich so Signale aus einem Teilbereich des Anregungsprofils jeden Pulses herausfiltern. Bei gleichzeitiger Anwendung von Magnetfeldgradienten während der Pulse lassen sich so Spins aus entsprechenden räumlichen Volumina beobachten.

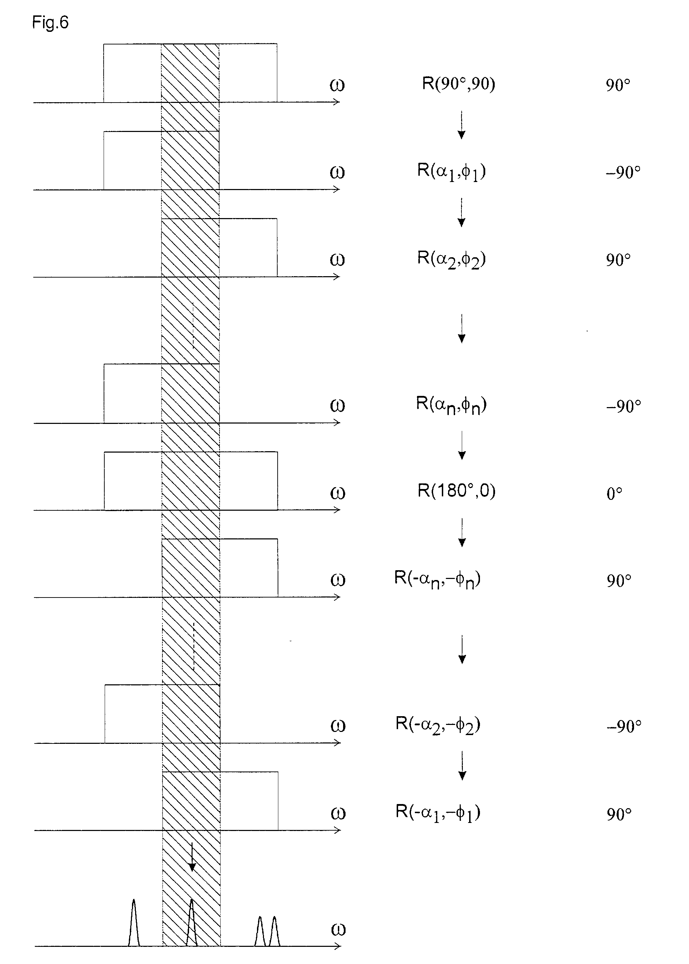

Fig.6 zeigt hierzu ein einfaches Anwendungsbeispiel, bei welchem die Profile der korrespondierenden bezüglich des zentralen 180°-Pulses symmetrischen Pulse jeweils gegeneinander verschoben sind, so dass eine Hyperecho-Bildung nur im überlappenden zentralen Spektralbereich (grau) erfolgt, während die Signale der äußeren Bereiche in Abhängigkeit von Phase und Flipwinkel der Pulse dephasiert erscheinen.

Eine besonders effektive Art dieser Hyperecho-Bildung ergibt sich dann, wenn die Phase der Pulse 1...n fortlaufend alterniert wird, da Spins in den äußeren Bereichen dann Pulse mit identischer Phase entsprechend einer Carr-Purrcel Sequenz sehen, für welche bekannt ist, dass sie für $\alpha < 180°$ zu sehr schnellen Signalverlust und damit zur Signalunterdrückung führt.

Es sind auch andere Implementierungen möglich, deren gemeinsames Merkmal ist, dass lediglich im Bereich des gewünschten Anregungsfensters die Bedingung zur Hyperecho-Bildung erfolgt ist. Eine besonders einfache Implementierung kann etwa auch dadurch erfolgen, dass lediglich der zentrale Refokussierungspuls eine gegenüber den anderen Pulsen der Hyperecho-Sequenz andere Selektivität (z.B. chemical shift selektiv) aufweist.

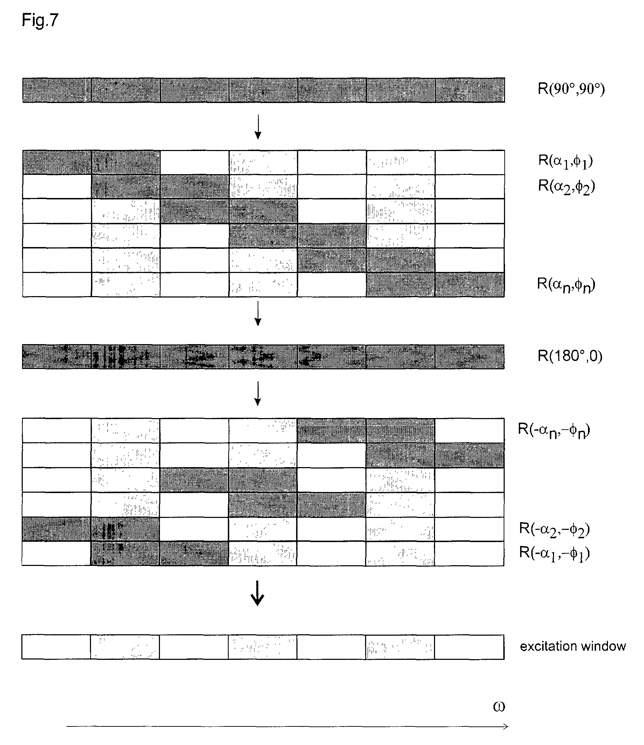

Eine Verallgemeinerung dieses Prinzips ist schematisch in Fig.7 gezeigt, wobei dargestellt wird, wie sich durch Anwendung einer Folge mit Pulsen mit einfachen Anregungsprofilen ein komplexes Anregungsfenster erreicht werden kann.

Eine andere Möglichkeit der Spinselektion ist dadurch möglich, dass die zeitliche Abfolge der Pulssequenz vor und/oder nach dem zentralen 180°-Puls durch einen Modulationsschritt $E(\varphi_E)$ modifiziert wird. Für den Fall der Einfügung vor dem zentralen 180°-Puls bewirkt die Pulsfolge dann nach Gln.[9]- [11]

$$M_R(Mx,My,Mz)= R(\alpha_1, 180°-\phi_1, \varphi_1)...* R(\alpha_{n-1}, 180°-\phi_{n-1}, \varphi_{n-1})*R(\alpha_n, 180°-\phi_n,\varphi_n)*$$

$$R(180°,0,0) * E(\varphi_E)*R(\alpha_n,\phi_n,\varphi_n)...*R(\alpha_2,\phi_2, \varphi_2)*R(\alpha_1,\phi_1, \varphi_1) M_A(Mx,My,Mz) \qquad [14].$$

Eine Hyperecho-Bildung tritt nur für den Anteil der Spins ein, für welchen die Magnetisierung unverändert bleibt, entsprechend der vektoriellen Zerlegung ist dies $M_R \cos(\varphi_E)$. Die entsprechende orthogonale Komponente $M'_R$ 'sieht' nach dem Intervall $E(\varphi_E)$ in ihrer Phase um 90° verschobene Pulse und entwickelt sich daher entsprechend

$$M'_R(Mx,My,Mz)= R(\alpha_1,90°-\phi_1,\varphi_1)*R(\alpha_{n-1},90°-\phi_{n-1}, \varphi_{n-1}) *R(\alpha_n,90°-\phi_n,\varphi_n)$$

$$*R(180°,90°,0) *E(\varphi_E)*R(\alpha_n,\phi_n,\varphi_n)...*R(\alpha_2,\phi_2,\varphi_2)*R(\alpha_1,\phi_1,\varphi_1) M_A(Mx,My,Mz) \qquad [15].$$

Bei entsprechender Wahl von $\phi_1...\phi_n$ wird dieser Signalanteil unterdrückt. Im einfachsten Fall gelingt dies für $\phi_1...\phi_n =0°$ und $\alpha_1 ... \alpha_n < 180°$.

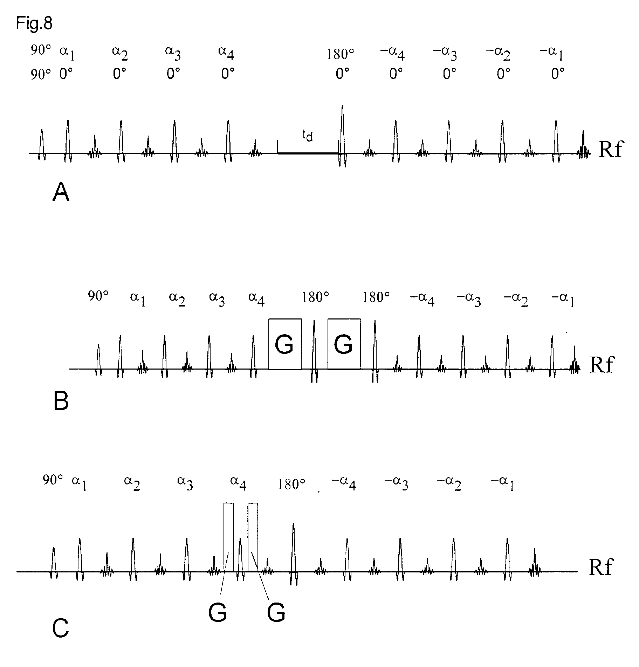

Wird E etwa als zusätzliches Zeitintervall $t_d$ repräsentiert (Fig.8A), so wird die Symmetrie der Hyperecho-Sequenz für Spins in Resonanz nicht gestört. Spins mit einer gewissen Offresonanzfrequenz $\omega > 0$ erfahren demgegenüber eine Phasenänderung $\Delta\varphi$ entsprechend $\Delta\varphi = \omega\, t_d$. Diese bewirkt eine Verletzung der Symmetrie der Hyperecho-Sequenz, und die Signale dieser Spins werden unterdrückt. $E(\varphi_E)$ kann jedoch auch wesentlich komplexer angelegt sein.

Fig.8B zeigt als weiteres Beispiel die Einführung eines zusätzlichen Spin-Echo Intervalls mit symmetrischen starken Magnetfeldgradienten. Durch diese Gradienten erfahren sich bewegende Spins eine Dephasierung. Bei gleichförmiger Bewegung aller Spins etwa im Falle von Fluss in Gefäßen führt dies zu einer geschwindigkeitsabhängigen Phasenänderung der observablen Magnetisierung, welche die Symmetriebedingung der Hyperecho-Bildung verletzt und daher zu einem Signalverlust des Hyperechos führt.

Spinensembles, welche sich infolge von molekularer Diffusion inkohärent bewegen, erfahren durch die inkohärente Dephasierung eine von der Diffusionskonstanten abhängige Amplitudenänderung, welche auch die Amplitude des nachfolgenden Hyperechos abschwächen wird, die Bildung des Hyperechos an sich wird jedoch durch Diffusion nicht beeinflusst.

Bei einer herkömmlichen Spin-Echo Sequenz werden mit konstanter Geschwindigkeit bewegte Spins ohne Signalverlust aber mit einer Änderung der Signalphase dargestellt. Bei einer Hyperecho-Sequenz, bei welcher der durch Gl.[14] wiedergegebene Signalanteil $M'_R(Mx,My,Mz)$ dephasiert vorliegt und daher nicht zum Gesamtsignal beiträgt, treten demgegenüber keine Phaseneffekte auf.

Eine bewegungsabhängige Änderung der Signalphase und damit ein Verlust der Hyperecho-Bildung tritt auch schon alleine dann auf, wenn lediglich um einen (oder mehrere) der Refokussierungspulse bei ansonsten gleichem Zeitschema ein bipolarer Magnetfeldgradient geschaltet wird (Fig.8C).

Die in den Figuren 8A bis 8C dargestellten Ausführungen einer modifizierten Hyperecho-Sequenz sind wiederum lediglich exemplarisch. In der Literatur (siehe z.B. (D9), (D10)) gibt es eine große Anzahl von Verfahrensschritten, welche eine gezielte Änderung der Signalphase und/oder Amplitude beinhalten und die sich sinngemäß auch in einer Hyperecho-Sequenz anwenden lassen.

Zu beachten ist, dass alle Modifikationen, welche bei Anwendung auf konventionelle Spin-Echo oder Gradienten-Echo Sequenzen zu einer Phasenänderung führen, bei der Hyperecho-Bildung einen Verlust an Signalintensität bewirken.

3.2. Hyperechos zur Unterdrückung der Signale gekoppelter Spins

Wie bereits eingangs erwähnt, gilt die Hyperecho-Refokussierung nach Gl.[11] bezüglich Mechanismen wie chemische Verschiebung, Suszeptibilität etc. also solchen Spinzuständen, welche durch eine zeitliche Entwicklung der Phase gekennzeichnet sind und welche durch einen 180°-Puls invertiert werden. Im Produktoperator-Formalismus der NMR ist dies für alle Zustände in der Diagonale der Dichtematrix erfüllt. Mechanismen wie Null- und Mehrquantenkohärenzen sowie J-Kopplung, welche in Außerdiagonalelementen repräsentiert werden, zeigen ein davon abweichendes Refokussierungsverhalten und unterliegen damit nicht oder zumindest nicht automatisch der Hyperecho-Bildung.

Andererseits lassen sich aber auch Pulsfolgen bilden, bei welchen die Symmetrie der Rotationen, welche der Hyperecho-Bildung zugrunde liegt, sich sinngemäß auf solche Mechanismen übertragen lassen, so dass dann selektiv ein Hyperecho etwa für gekoppelte Systeme gebildet wird, nicht jedoch für ungekoppelte Spins. Durch entsprechende Wahl von $\alpha_n, \phi_n, \varphi_n$ lassen sich so die entsprechenden Spinzustände diskriminieren.

Im folgenden sollen einige typische Anwendungen für gekoppelte Spins exemplarisch dargestellt werden. Auch diese Darstellung ist nur exemplarisch und keineswegs vollständig. Weitere Anwendungen für andere Zustände wie Null- und Mehrquantenkohärenzen lassen sich aus der Grundgleichung [11] ohne weiteres ableiten.

Spinsysteme mit J-Kopplung haben ein anderes Refokussierungsverhalten als gekoppelte Spinsysteme. Im folgenden wird dies an einem AX-System demonstriert, eine Erweiterung auf andere Systeme ist ohne weiteres möglich. Ein AX-System ist als schwach gekoppeltes System charakterisiert, bei welchem der Unterschied der chemischen Verschiebungen der A- und X-Kerne größer ist als die Kopplungskonstante J. Ein solches System ist durch zwei Dubletts charakterisiert. Wendet man auf ein solches System einen Refokussierungspuls an, so werden zum einen die Magnetisierungen refokussiert, zum andern jedoch simultan die entsprechenden Kopplungspartner vertauscht, das heißt, durch diese doppelte Inversion verhält sich das Spinsystem nachfolgend bezüglich der J-Kopplung so, als ob keine Refokussierung stattgefunden hätte.

Bei Anwendung von Refokussierungspulsen mit exakt 180° Flipwinkel führt dies dazu, dass die Phase der Echos von gekoppelten Spins sich anders entwickelt als die von ungekoppelten Spins. Dies ist die Grundlage von Verfahren wie COSY etc.

Bei Anwendung von mehreren Pulsen, welche zudem in ihrem Flipwinkel von 180° abweichen, führt diese Phasenentwicklung zu zunehmend destruktiver Interferenz und damit zum Signalverlust. So tritt insbesondere bei CPMG-Sequenzen ein Verlust der positiven Interferenz der unterschiedlichen Signalbeiträge entsprechend Ref. (D3) ein, sofern der Pulsabstand gegenüber J und $\Delta\sigma$ ausreichend groß ist (D8). Es ist daher möglich, die Signale gekoppelter Spins durch eine entsprechende Multipulssequenz zu unterdrücken. Obwohl im Prinzip bekannt, wird ein solches Verfahren in der Praxis nicht häufig angewandt, da die notwendige Bedingung der Verwendung von Flipwinkeln < 180° zu einem Signalverlust der beobachteten ungekoppelten Spins führt und dieses Verfahren damit gegenüber anderen Diskrimierungsverfahren benachteiligt ist.

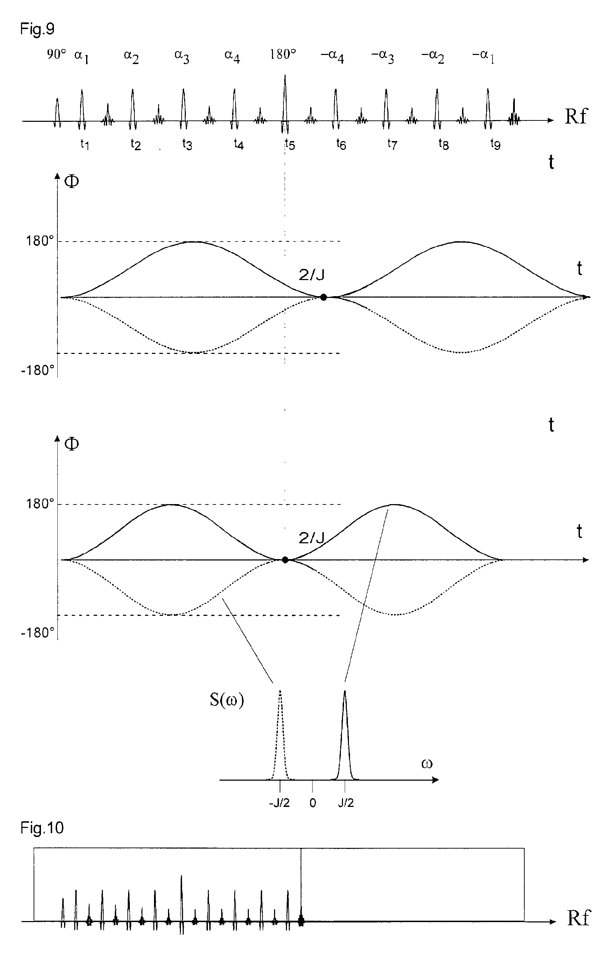

Demgegenüber führt eine Sequenz, welche bezüglich der Signale ungekoppelter Spins zur Bildung eines Hyperechos führt, zur vollen Signalintensität, wogegen Signale gekoppelter Spins unterdrückt werden, da sie effektiv eine andere Phase der Refokussierungspulse 'sehen'. Hierzu betrachten wir ein solches Dublett-signal und nehmen an, dass die Referenzfrequenz im Zentrum des Dubletts ist. Das Dublettsignal wird dann eine Phasenentwicklung entsprechend cos(J/2 *tn) erfahren, wobei tn die Zeit nach der Anregung kennzeichnet (Fig.9).

Ein besonders vorteilhaftes Kennzeichen dieser Anwendung ist dadurch gegeben, dass sich bei entsprechender Wahl von $\alpha_n, \phi_n, \varphi_n$ Signale von Spins aus Systemen mit unterschiedlichen Kopplungskonstanten gleichzeitig unterdrücken lassen.

Die Unterdrückung der Signale gekoppelter Spins wird vermieden, wenn der Zeitpunkt des zentralen 180°. Pulses = 1/J gewählt wird (Fig.9 unten). Dies ist natürlich nur für Spins mit einer Kopplungskonstante J erfüllt.

Dieses Prinzip der unterschiedlichen Phasenentwicklung lässt sich auch umgekehrt zur Selektion gekoppelter Spins durchführen. Dies wird dadurch erreicht, dass die Phasenentwicklung entsprechend der J-Kopplung in den Phasen $\phi_n$ der Refokussierungspulse berücksichtigt wird. Modifiziert man nun eine Hyperecho-Sequenz nach Gl.[11] so, dass jede Pulsphase $\phi_n$ um arcsin(J/2 *$t_n$) inkrementiert wird, so sieht man, dass nun die Bildung eines Hyperechos nur für das entsprechende Signal erfolgen kann, während für Signale mit anderen Kopplungskonstanten und auch für Signale ungekoppelter Spins die Symmetriebeziehung nach Gl.[11] verletzt ist und diese daher abgeschwächt erscheinen, wobei sich schon mit wenigen Refokussierungspulsen eine Abschwächung erreichen lässt, welche zu einer praktisch vollständigen Unterdrückung dieser Signale führt.

Entsprechend diesem einfachen Beispiel lässt sich eine große Anzahl von Pulsfolgen konzipieren, deren gemeinsames Merkmal es ist, dass die Symmetriebeziehung zur Hyperecho-Bildung jeweils nur für die zu beobachtenden Spins erfüllt ist, für andere jedoch verletzt wird. Dies gilt insbesondere auch für Null- und Mehrquantenkohärenzen, für welche Hyperecho-Verfahren mit entsprechender Selektion oder Unterdrückung der unterschiedlichen zugeordneten Signale aus der Beschreibung bezüglich der J-Kopplung ohne weiteres abgeleitet werden kann.

Aus der Betrachtung, dass bei Verletzung der Symmetrie der Phaasenentwicklung entsprechend obigem Kapitel 3 lediglich der cosinus-Anteil der Magnetisierung zur Hyperecho-Bildung beiträgt, ergibt sich die Möglichkeit der Verwendung der Hyperecho-Bildung als Polarisationsfilter, welches nur Signale, deren Symmetrie der Hyperecho-Sequenz folgen, durchlässt und die dazu orthogonalen Signalbeiträge löscht. So lassen sich durch Anwendung mehrerer solcher Polarisatoren mit ggf. Selektion unter verschiedenen Polarisationswinkeln sehr spezifisch Signale selektieren, deren Dephasierung entsprechenden und präzisen Vorgaben gehorcht.

4. Spin-Inversion

Die Anwendung einer Sequenz nach Gl.[11] auf reine z-Magnetisierung führt zur Spin-Inversion, wie sie etwa für sogenannte Inversion-recovery Sequenzen zur T1-Messung benutzt werden oder auch im Bereich der Bildgebung zur Erlangung T1-gewichteter Bilder. Die Anwendung einer Hyperecho-Sequenz erlaubt dabei gegenüber einer konventionellen Inversion mit einem einzelnen 180°-Puls die Anwendung der unter Kapitel 3. beschriebenen Verwendung von Methoden zur selektiven Spin-Inversion. Insbesondere lassen sich so zum einen komplexe Inversionsprofile erreichen, zum andern ist auch eine selektive Inversion entsprechend der chemischen Verschiebung, J-Kopplung, verschiedener Null- und Mehrquantenkohärenzen u.v.m. möglich.

Implementierung

Bei der Implementierung ist zu unterscheiden, dass die Bildung von Hyperechos zum einen in den Ablauf der Messung mit einer bestimmten Pulssequenz integriert werden kann, was sich vor allem für die in den obigen Kapiteln 1. und 2. genannten Sequenzen als vorteilhaft erweist. Für alle genannten Sequenzen sind jedoch auch Implementierungen möglich und u.U. sogar vorteilhaft, bei welchen die Bildung eines Hyperechos zunächst zur gezielten Präparation des Spinsystems dient und die Datenakquisition nachfolgend ausgeführt wird (entsprechend Fig.2D).

Das Akquisitionsmodul kann dabei entweder aus einer reinen Auslesephase als free induction decay oder spin-echo erfolgen. Vor allem bei Anwendungen in der MR-Tomographie kann das Auslesemodul aber auch aus einem entsprechenden Imaging-Modul (Gradientenecho, echo planar imaging, RARE(TSE,...), Spiral scan etc.) bestehen, so dass Bilder mit einem Kontrast entsprechend der Charakteristik des Hyperechos entstehen.

Darüber hinaus gibt es weitere Anwendungen, bei welchen Hyperechos in einem zum bisherigen etwas unterschiedlichen Kontext eingesetzt werden. So ist aus der Literatur bekannt (D3), dass in Mehrpulssequenzen eine mit der 3. Potenz der Zahl der Pulse wachsende Anzahl möglicher Refokussierungspfade für transversale Magnetisierung entstehen, von denen häufig nur ein Teil tatsächlich zur Signalauslesung beitragen soll. Bei Wiederholung einer solchen Sequenz mit einer Wiederholzeit, die kleiner ist, als die longitudinale Relaxationszeit T1 kann es daher zur Bildung unerwünschter Signale kommen. Diese lassen sich durch Hyperecho-Bildung vermeiden, da hierdurch sämtliche Refokussierungspfade wieder zusammengeführt werden. Eine solche 'clean-up' Funktion kann insbesondere auch bei der Verwendung der NMR im Quantum Computing sinnvoll sein, da die Hyperecho-Bildung hier als Löschfunktion der im Spinsystem als Transversalmagnetisierung gespeicherte Information dienen kann.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:

Fign. 1A bis 1C    eine Demonstration der Symmetriebeziehung bezüglich der Rotation;

Fig. 2A    eine Hyperecho-Sequenz;

Fig. 2B    das Prinzip der Anwendung einer Hyperecho-Sequenz durch Integration;

| Fig. 2C | das Prinzip der Anwendung einer Hyperecho-Sequenz durch Ergänzung; |
| Fig. 2D | das Prinzip der Anwendung einer Hyperecho-Sequenz als Präparationssequenz; |
| Fig. 3 | eine Pulsfolge einer modifizierten CPMG-Sequenz entsprechend dem erfindungsgemäßen Verfahren; |
| Fig. 4 | das Prinzip der Anwendung des Hyperecho-Mechanismus; |
| Fign. 5A bis 5G | Hyperecho-Sequenzen auf der Basis von GradientenechoSequenzen; |
| Fig. 6 | eine schematische Darstellung des Prinzips der Spinselektion; |
| Fig. 7 | ein verallgemeinertes Schema des in Fig. 6 dargestellten Prinzips zur Demonstration, wie sich ein komplexes Anregungsfenster aus einer Hyperecho-Sequenz mit Pulsen mit verschobenem Anregungsprofil realisieren lässt; |
| Fign. 8A bis 8C | modifizierte Hyperecho-Sequenzen; |
| Fig. 9 | den Effekt von J-Kopplung auf die Hyperecho-Bildung; und |
| Fig. 10 | ein allgemeines Schema einer Messsequenz mit HyperechoPräparationsmodul und ausschließendem Akquisitionsmodul. |

Fig. 1A zeigt die Symmetrie bezüglich Rotation um die z-Achse entsprechend den Gleichungen [4] und [8], also senkrecht zur Bildebene, aus welcher folgt, dass der aus V durch Rotation um z mit $\varphi$, nachfolgender Rotation um y mit 180° und nachfolgender erneuerter Rotation um z mit $\varphi$ (Pfeile) erhaltene Vektor V* identisch ist wie bei einer Rotation von V um y mit 180° (gestrichelter Pfeil). Die zur Bildebene senkrechte y-Achse markiert den Nullpunkt der x-z-Ebene.

Fig. 1B zeigt die Symmetrie bezüglich der Rotation um die y-Achse entsprechend Gl.[5], bei welcher trivialerweise gilt, dass eine Folge von Rotationen um y mit $\alpha$, 180° und -$\alpha$ identisch ist zu einer Rotation um 180°.

Fig. 1C zeigt die Symmetrie bezüglich der Rotation um eine gegenüber der y-Achse um $\phi$ gekippten Drehachse entsprechend Gl.[6]. Entsprechend der Darstellung in Aufsicht ist der Pol der Drehachse gegenüber dem durch die y-Achse definierten Nullpunkt um $\sin(\phi)$ verschoben.

Die Hochfrequenzimpulse mit Flipwinkeln $\alpha_1$.. $\alpha_n$ und der jeweiligen Phase $\phi_1$..$\phi_n$ sind in Fig. 2A von Dephasierungsintervallen $\varphi_1$... $\varphi_n$ getrennt. Nach einem zentralen Refokussierungsimpuls wird die Sequenz in umgekehrter Reihenfolge mit Pulsen mit entgegengesetzter Phase und Amplitude angewendet, auch die Reihenfolge der Dephasierungsintervalle wird umgekehrt, die Dephasierungen $\varphi_1$... $\varphi_n$ bleiben jedoch identisch. Unabhängig von der Art der Magnetisierung am Beginn der Sequenz wird diese durch die Pulsfolge um die Drehachse des Refokussierungspulses refokussiert.

In eine bestehende Sequenz (hier: einfaches Spin-Echo-Experimentes mit einem 90° und einem 180°-Puls (dicke Linien)) werden bei Fig. 2B zusätzliche Pulse entsprechend dem in Fig.2A gezeigten Grundprinzip eingefügt, so dass statt der Bildung eines normalen Spin-Echos ein Hyperecho gebildet wird.

Eine bestehende Sequenz (hier: Multiecho-Experiment mit n Refokussierungspulsen) wird in Fig. 2C um einen 180°-Puls sowie der umgekehrten Pulsfolge ergänzt, so dass es zur Bildung eines Hyperechos kommt. Der initiale Anregungsimpuls (im allgemeinen ein 90°-Puls) wird üblicherweise nicht in die Komplementierung einbezogen, so dass das Hyperecho als Signal transversaler Magnetisierung entsprechend der Magnetisierung nach dem 90°-Puls entsteht.

In Fig. 2D wird einer herkömmlichen Sequenz (hier wieder Spin-Echo) eine Hyperecho-Sequenz vorangestellt, um das Kontrastverhalten entsprechend der gegebenenfalls modifizierten Hyperecho-Sequenz zu modifizieren.

Die Refokussierungspulse $\alpha_n$ nach Fig. 3 sind im allgemeinen < 180° und können auch untereinander verschieden sein. Die Refokussierung zur vollen Echoamplitude kann ein- (oben) oder mehrmals (unten) erfolgen. Bei Anwendung in der Bildgebung sind zusätzlich entsprechende geschaltete Magnetfeld-Gradienten (z.B. nach (D3)).

Zum Zeitpunkt der Bildung des Hyperechos wird gemäß Fig. 4a,4b ein -90°-Puls angewendet. Während des Multiechozugs zerfällt die transversale Magnetisierung Mtr entsprechend der Spin-Relaxation, die z-Magnetisierung Mz erholt sich mit T1. Die Relaxationskurven sind lediglich schematisch dargestellt. Die voll refokussierte transversale Magnetisierung zum Zeitpunkt der Hyperecho-Bildung wird in z-Magnetisierung $M_{DE}$ überführt. Diese ist sehr viel näher am Gleichgewichtswert $M_0$ als die z-Magnetisierung $M_{sat}$ ohne Flipback (gestrichelt).

In den Figuren 5A bis 5D bezeichnen Rf, GS, GR und GP die Hochfrequenzpulse, den Schichtselektions-, Lese- und Phasenkodiergradient. Zunächst werden in Fig. 5A durch m-fache Wiederholung m Gradientenechos erzeugt, wobei Flipwinkel $\alpha$ und Phase $\phi$ der verwendeten Pulse frei gewählt werden können und im einfachsten (aber nicht unbedingt bevorzugten) Fall konstant sind. Anschließend wird der Refokussierungspuls (im einfachsten Fall als 180°-Puls) angelegt und schließlich die Gradientenchosequenz m-fach wiederholt, wobei Flipwinkel und Phase der verwendeten Pulse durch GI.[11] bestimmt sind. Die Zahl der Wiederholungen m kann dabei frei gewählt werden, so dass ein zur Bildrekonstruktion benötigter vollständiger Datensatz durch eine einzelne Anwendung oder aber auch durch mehrfache Wiederholung dieser Sequenz entsteht.

Bei Anwendung auf z-Magnetisierung führt der Hyperecho-Mechanismus zur Inversion. Um ein Hyperecho als transversale Magnetisierung zu realisieren, kann der Sequenz ein Anregungspuls mit im einfachsten Fall 90° Flipwinkel vorangestellt werden, wie in Fig. 5B dargestellt.

Fig. 5C zeigt einen Ausschnitt aus einer Gradientenechosequenz mit mehreren Hyperechos, wobei auch hier eine Signalpräparation etwa durch einen 90°-Puls wie i Fig. 5B vorangestellt sein kann.

Fig. 5D zeigt eine Driven Equilibrium-Sequenz, bei welcher das gebildete Hyperecho durch einen entsprechenden Flipback-puls in z-Magnetisierung übergeführt wird.

Die für die Hyperecho-Bildung verwendeten Pulse gemäß Fig. 6 haben jeweils gegeneinander verschobene Anregungsprofile, so dass die Bedingung zur Bildung eines Hyperechos nur für Spins, deren Resonanzfrequenz im Überlappungsbereich (grau) liegt, erfüllt ist. Signale von Spins, welche nur von einem Teil der Pulse erfasst wird und für welche die Bedingung zur Hyperecho-Bildung nicht erfüllt ist, werden dagegen unterdrückt. Die Dephasierungsintervalle $\varphi$ zwischen den Pulsen sind nicht dargestellt.

Die Pulse in Fig. 7 weisen jeweils unterschiedliche Anregungsprofile (dunkelgrau) auf. Die Hyperecho-Bedingungen sind lediglich für einzelne spektrale Fenster (hellgrau) erfüllt.

Fig. 8A zeigt eine aus der in Fig.3 gezeigten CPMG-Hyperecho-Sequenz abgeleitete Sequenz, bei welcher ein zusätzliches Zeitintervall td vor dem zentralen 180°-Puls eingeführt wurde. Für Spins, welche während td eine Änderung der Signalphase erleiden, ist der Hyperecho-Refokussierungsmechanismus nicht mehr erfüllt.

Fig. 8B zeigt eine Sequenz bei welcher durch ein zusätzliches Spin-Echo Intervall mit symmetrischen Magnetfeldgradienten G eine bewegungsabhängige Änderung der Signalphase bewirkt wird, welche ebenfalls zum Verlust der Hyperecho-Bildung führt.

Fig. 8C zeigt, dass eine bewegungsabhängige Änderung der Signalphase und damit eine Änderung der Amplitude des Hyperechos auch bereits durch entsprechende Magnetfeldgradienten alleine in einer ansonsten unveränderten Hyperecho-Sequenz bewirkt werden kann.

Bei gekoppelten Spins tritt infolge der J-Kopplung eine periodische Phasenänderung $\Phi$ der beiden Signale des Dubletts ein, dessen Spektrum $S(\omega)$ durch ein Dublett charakterisiert ist, wie in Fig. 9 dargestellt. Wird auf ein solches Dublett eine Hyperecho-Sequenz angewendet, so wird die Phase $\phi_n$ jedes Pulses formal um $+\text{-}\arcsin(t_n * J/2)$ verändert, wobei $t_n$ der Zeitpunkt der Pulse ist. Im allgemeinen wird dadurch die Symmetrie der Hyperecho-Bildung gestört und die Signale gekoppelter Spins werden nicht refokussiert. Wird der Zeitpunkt des zentralen 180°-Pulses allerdings = 1/J gewählt, so bleibt die Symmetrie erhalten, solche Dubletts werden abgebildet.

Fig. 10 schließlich stellt eine Messsequenz dar, bei welcher zunächst Magnetisierung über Hyperecho-Bildung (ggf. mit einer der beschriebenen Modifikationen) erzeugt und anschließend mit einer beliebigen Auslese-Sequenz ausgelesen wird.

Literatur:

(D1) Hahn E L, Spin Echoes, Phys.Rev. 80:580-594 (1950)

(D2) Meiboom S, Gill D, Modified Spin-Echo Method for Measuring Nuclear Relaxation Times, Review of Scientific Instruments, 29:688-691 (1958)

(D3) Hennig J, Multiecho Imaging Sequences with Low Refocusing Flip Angles, J.Magn.Reson., 78:397-407 (1988)

(D4) Le Roux P, Hinks RS, Stabilization of echo amplitudes in FSE sequences, Magn Reson Med. 30:183-90 (1993)

(D5) Alsop DC, The sensitivity of low flip angle RARE imaging, Magn Reson Med. 37:176-84 (1997)

(D6) Gullion T, Baker DE, Conradi MS., J.Magn.Reson. 89, 479 (1990)

(D7) van Uijen CM, den Boef JH, Driven-equilibrium radiofrequency pulses in NMR imaging, Magn Reson Med. 1984 Dec;1(4):502-7.

(D8) Hennig J, Thiel T, Speck O, Improved Sensitivity to Overlapping Multiplet Signals in in vivo Proton Spectroscopy Using a Multiecho Volume Selective (CPRESS-) Experiment, Magn Reson Med. 37: 816-20 (1997)

(D9) Haase A, Snapshot FLASH MRI. Applications to T1, T2, and chemical-shift imaging, Magn Reson Med. 13: 77-89 (1990)

(D10) Norris D G, Ultrafast low-angle RARE: U-FLARE, Magn Reson Med. 17: 539-542(1991)

**Patentansprüche**

1.  Verfahren der NMR(= Kernspinresonanz)-Spektroskopie bzw. NMR-Tomographie, bei welchem auf ein Spinensemble eine Folge von zeitlich gegeneinander versetzten Hochfrequenzimpulsen angewendet wird, von denen mindestens einer als Refokussierungspuls ausgebildet ist,
    **dadurch gekennzeichnet,**
    **dass** nach einer Sequenz von Pulsen mit Flipwinkel $\alpha_1 \dots \alpha_n$ (mit $\alpha_1 \dots \alpha_n \geq 0°$) und Phasen $\phi_1 \dots \phi_n$, zwischen denen Spins jeweils Dephasierungen $\varphi_1 \dots \varphi_n$ erfahren, als (n+1)ter Puls ein zentraler Refokussierungspuls angewendet wird, gefolgt von einer Pulssequenz, deren Folge spiegelsymmetrisch zum zentralen Refokussierungspuls ist, wobei die Flipwinkel $\alpha_{n+2} \dots \alpha_{2n+1}$ und Phasen $\phi_{n+2} \dots \phi_{2n+1}$ der Pulse im Vergleich mit den dazu spiegelsymmetrisch angeordneten Pulsen mit $\alpha_n \dots \alpha_1$ und $\phi_n \dots \phi_1$ in Bezug auf Amplitude und Phase jeweils negatives Vorzeichen aufweisen und die in der Folge ebenfalls spiegelsymmetrisch zum zentralen Refokussierungspuls angeordneten Dephasierungen $\varphi_{n+2} \dots \varphi_{2n+1}$ den jeweiligen spiegelsymmetrischen Dephasierungen $\varphi_n \dots \varphi_1$ gleich sind, so dass am Ende der Pulsfolge eine Ausgangsmagnetisierung $M_A$(Mx,My,Mz) des Spinensembles bezüglich des zentralen Refokussierungspulses durch Anwendung einer Rotation entsprechend der Symmetriebeziehung

    $$M_R(-Mx,My,-Mz) = Rot_y(180°) * M_A(Mx,My,Mz)$$

    in eine Endmagnetisierung $M_R$ = (-Mx,My,-Mz) übergeführt und unter Vernachlässigung von Relaxationseffekten refokussiert ist (=Hyperecho-Bildung).

2.  Verfahren nach Anspruch 1, **dadurch gekennzeichnet, dass** der Refokussierungspuls einen Flipwinkel von 180° aufweist.

3.  Verfahren nach einem der vorhergehenden Ansprüche, **dadurch gekennzeichnet, dass** eine Pulssequenz entsprechend der Hyperecho-Bildung auf z-Magnetisierung angewendet wird, so dass am Ende der Sequenz die z-Magnetisierung invertiert vorliegt.

4.  Verfahren nach Anspruch 3, **dadurch gekennzeichnet, dass** die Phase des auf das Hyperecho angewendeten Hochfrequenzpulses gleich der des Anregungspulses ist, so dass die anfängliche z-Magnetisierung invertiert vorliegt, wodurch die Zeit bis zur Einstellung des thermischen Gleichgewichts des angeregten Spinsystems verlängert bzw. bei Wiederholung der Sequenz mit konstanter Erholzeit die Intensität der Signale, welche zum Hyperecho beitragen, erniedrigt wird.

5.  Verfahren nach Anspruch 3 oder 4, **dadurch gekennzeichnet, dass** auf das Spinsystem von z-Magnetisierung eine Hyperecho-Sequenz angewendet wird, wodurch die Magnetisierung in eine -z-Magnetisierung übergeführt wird, gefolgt von einem Inversionspuls, welcher das Spinsystem wiederum in +z-Magnetisierung überführt, wodurch die Zeit bis zur Einstellung des thermischen Gleichgewichts des angeregten Spinsystems verkürzt bzw. bei Wiederholung der Sequenz mit konstanter Erholzeit die Intensität der Signale, welche zum Hyperecho beitragen, erhöht wird.

6.  Verfahren nach einem der Ansprüche 1 oder 2, **dadurch gekennzeichnet, dass** eine Pulssequenz entsprechend der Hyperecho-Bildung auf transversale Magnetisierung angewendet wird, so dass am Ende der Sequenz die transversale Magnetisierung refokussiert vorliegt.

7.  Verfahren nach Anspruch 6, **dadurch gekennzeichnet, dass** im Spinsystem durch einen Anregungsimpuls transversale Magnetisierung erzeugt wird, welche durch Bildung eines Hyperechos am Ende einer Multipulssequenz refokussiert wird, wobei die transversale Magnetisierung des Hyperechos mittels eines gegenüber dem Anregungsimpuls gegenphasigen Hochfrequenzimpuls in z- Magnetisierung übergeführt wird, wodurch die Zeit bis zur Einstellung des thermischen Gleichgewichts des angeregten Spinsystems verkürzt bzw. bei Wiederholung der Sequenz mit konstanter Erholzeit die Intensität der Signale, welche zum Hyperecho beitragen, erhöht wird.

8. Verfahren nach einem der vorhergehenden Ansprüche, **dadurch gekennzeichnet, dass** die Messsequenz aus einem Anregungsimpuls mit nachfolgender mehrfacher Refokussierung im Sinne einer Multiecho-Sequenz besteht dergestalt, dass eine Hyperecho-Bildung während der Multiecho-Sequenz einfach oder durch Wiederholung mehrfach durchgeführt wird, so dass es zur Ausbildung von einem oder mehreren Hyperechos kommt.

9. Verfahren nach einem der vorhergehenden Ansprüche, **dadurch gekennzeichnet, dass** die zur Hyperecho-Bildung notwendige Symmetrie durch einen Modulationsschritt E gestört wird, so dass lediglich Spins, deren Phase durch den Modulationsschritt nicht gestört wird, zur Hyperecho-Bildung beitragen, während Spins, bei welchem durch den Modulationsschritt eine Änderung ihrer Phase bewirkt wird, ein entsprechend abgeschwächtes Hyperecho gebildet wird.

10. Verfahren nach einem der vorhergehenden Ansprüche, **dadurch gekennzeichnet, dass** eine Spin-Selektion derart durchgeführt wird, dass die Phase von Signalen von Spins mit J-Kopplung, Null- und Mehrquantenkohärenzen, von der Phase von Spins in ungekoppelten Signale abweicht, so dass die Bildung eines Hyperechos nur für ungekoppelte Spins erfolgt.

11. Verfahren nach einem der vorhergehenden Ansprüche, **dadurch gekennzeichnet, dass** eine Spin-Selektion derart durchgeführt wird, dass dass die Phase der Hochfrequenzimpulse der Phasenentwicklung von Spins mit J-Kopplung, Null- und Mehrquantenkohärenzen etc. folgt, so dass die Bildung eines Hyperechos nur für diejenigen Spins erfolgt, bezüglich derer die Bedingungen zur Hyperecho-Bildung erfüllt ist.

12. Verfahren nach einem der vorhergehenden Ansprüche, **dadurch gekennzeichnet, dass** die Hyperecho-Bildung auf Basis einer Sequenz der Bildgebung, vorzugsweise RARE, GRASE, Echo Planar Imaging, FLASH, oder Spiral Imaging erfolgt.

13. Verfahren nach einem der Ansprüche 1 bis 11, **dadurch gekennzeichnet, dass** die Bildung eines Hyperechos nach Anregung des Spinsystems durchgeführt wird und anschließend eine Signalauslesung des Hyperechos erfolgt.

14. Verfahren nach Anspruch 13, **dadurch gekennzeichnet, dass** zur Signalauslesung eine Sequenz der Bildgebung, vorzugsweise RARE, Echo Planar Imaging, Snapshot-FLASH oder Spiral Imaging verwendet wird.

15. Verfahren nach einem der Ansprüche 1 bis 11, **dadurch gekennzeichnet, dass** eine Messsequenz auf mehrere Kerne mit unterschiedlichem gyromagnetischem Verhältnis angewendet wird, wobei bei der auf mindestens einen Kern wirkende Teilsequenz eine Hyperecho-Bildung erfolgt.

Fig.1

Fig.2

Fig.3

| 90° | $\alpha_1$ | $\alpha_2$ | $\alpha_3$ | $\alpha_4$ | 180° | $-\alpha_4$ | $-\alpha_3$ | $-\alpha_2$ | $-\alpha_1$ | flip angle |
| 90° | 0° | 0° | 0° | 0° | 0° | 0° | 0° | 0° | 0° | pulse phase |

Rf

Hyper-
Echo

| 90° | $\alpha_1$ | $\alpha_2$ | 180° | $-\alpha_2$ | $-\alpha_1$ | $\alpha_3$ | $\alpha_4$ | 180° | $-\alpha_4$ | $-\alpha_3$ | flip angle |
| 90° | 0° | 0° | 0° | 0° | 0° | 0° | 0° | 0° | 0° | 0° | pulse phase |

Rf

Hyper-          Hyper-
Echo            Echo

Fig.4

| 90° | $\alpha_1$ | $\alpha_2$ | $\alpha_3$ | $\alpha_4$ | 180° | $-\alpha_4$ | $-\alpha_3$ | $-\alpha_2$ | $-\alpha_1$ | -90° | 180° | flip angle |
| 90° | 0° | 0° | 0° | 0° | 0° | 0° | 0° | 0° | 0° | -90° | | pulse phase |

A)                                                                 Rf

| 90° | $\alpha_1$ | $\alpha_2$ | $\alpha_3$ | $\alpha_4$ | 180° | $-\alpha_4$ | $-\alpha_3$ | $-\alpha_2$ | $-\alpha_1$ | -90° | flip angle |
| 90° | 0° | 0° | 0° | 0° | 0° | 0° | 0° | 0° | 0° | 90° | pulse phase |

B)                                                                 Rf

Mtr

Mz

$M_0$

$M_{DE}$

$M_{sat}$

Fig.5

A

B

C

D

E

F

G

Fig.6

| | |
|---|---|
| $R(90°,90)$ | $90°$ |
| $\downarrow$ | |
| $R(\alpha_1,\phi_1)$ | $-90°$ |
| $\downarrow$ | |
| $R(\alpha_2,\phi_2)$ | $90°$ |
| $\downarrow$ | |
| $R(\alpha_n,\phi_n)$ | $-90°$ |
| $\downarrow$ | |
| $R(180°,0)$ | $0°$ |
| $\downarrow$ | |
| $R(-\alpha_n,-\phi_n)$ | $90°$ |
| $\downarrow$ | |
| $R(-\alpha_2,-\phi_2)$ | $-90°$ |
| $\downarrow$ | |
| $R(-\alpha_1,-\phi_1)$ | $90°$ |

Fig.7

R(90°,90°)

R($\alpha_1$,$\phi_1$)
R($\alpha_2$,$\phi_2$)

R($\alpha_n$,$\phi_n$)

R(180°,0)

R($-\alpha_n$,$-\phi_n$)

R($-\alpha_2$,$-\phi_2$)
R($-\alpha_1$,$-\phi_1$)

excitation window

$\omega$

Fig.8

A

B

C

Fig.9

Fig.10